# EUROPEAN PATENT SPECIFICATION

(11) **EP 0 593 031 B1**
(45) Date of publication and mention of the grant of the patent: **17.12.1997**
(21) Application number: 93116557.5
(22) Date of filing: 13.10.1993
(51) Int. Cl.: H01S 3/085, H01S 3/025, G11B 7/125

(54) **Method of manufacturing a semiconductor laser**
Verfahren zur Herstellung eines Halbleiterlasers
Méthode de production d'un laser à semiconducteur

(30) Priority: 14.10.1992 JP 276213/92
(43) Date of publication of application: 20.04.1994
(73) Proprietor: SONY CORPORATION, Tokyo (JP)
(72) Inventor: Futatsugi, Makoto, c/o Sony Corporation, Tokyo (JP); Ando, Katsumi c/o Sony Corporation, Tokyo (JP); Yamamoto, Tadashi c/o Sony Corporation, Tokyo (JP)
(74) Representative: Müller, Frithjof E., Dipl.-Ing.

(56) References cited:
- JP-A- 4 230 024
- PATENT ABSTRACTS OF JAPAN vol. 14, no. 187 (E-917) 16 April 1990 & JP-A-02 035 788 (MITSUMI ELECTRIC IND CO LTD)
- PATENT ABSTRACTS OF JAPAN vol. 12, no. 498 (E-698) 24 December 1988 & JP-A-63 208 293 (HITACHI LTD)
- PATENT ABSTRACTS OF JAPAN vol. 14, no. 483 (E-993) 22 October 1990 & JP-A-02 199 889 (TOSHIBA CORP)
- PATENT ABSTRACTS OF JAPAN vol. 14, no. 268 (E-939) 11 June 1990 & JP-A-02 084 786 (MATSUSHITA ELECTRIC IND CO LTD)
- PATENT ABSTRACTS OF JAPAN vol. 13, no. 62 (E-715) 13 February 1989 & JP-A-63 250 186 (NEC CORP)

## Description

### BACKGROUND OF THE INVENTION

### Field of the Invention:

The present invention relates to a method of manufacturing a semiconductor laser such as a laser diode, and more particularly to a method of manufacturing such a semiconductor laser suitable for use as a light source in an optical system such as an optical pickup for reading information recorded on a magnetooptical disk or the like.

### Description of the Prior Art:

Optical systems such as optical pickups for reading information recorded on a magnetooptical disk or the like incorporate a semiconductor laser such as a laser diode as a light source. Generally, the semiconductor lasers have a mirror surface formed in a cleavage plane. It is known in the art, cf. Patent Abstracts of Japan, vol. 14, no. 187 (E-917), 16 April 1990, that light returning from the optical system combined with a semiconductor laser is reflected by a front end surface of the mirror surface and reenters the optical system, causing a variety of noise-induced problems. If the reentry of light from the optical system into the semiconductor laser occurs in a three-spot optical disk pickup, then tracking control is adversely affected.

In order to alleviate the above drawback, it has been proposed to reduce the thickness of the pellet itself of the semiconductor laser for thereby allowing as much of the reentrant light from the optical system as possible to pass behind the semiconductor laser pellet.

However, since a wafer from which semiconductor laser pellets are cut out is also reduced in thickness, the mechanical strength of the wafer is lowered. While semiconductor lasers are being fabricated, they have to be handled with utmost care as they tend to be easily damaged. Therefore, the fabrication process is low in efficiency and suffers a high rate of defective semiconductor lasers in the yield.

According to another proposal, the front end surface of the mirror surface of the semiconductor laser, except for a laser emission area, is coated with a material having a low reflectance or a material having a high absorptance. The process of coating such a material is, however, practically complex and difficult to carry out.

Patent Abstracts of Japan, vol. 14, no. 268 (E-939), 11 June 1990 discloses a semiconductor laser device and a method of manufacture thereof. A beam-recovering region of an end face of the laser chip is roughened by etching to reduce the reflectivity of the end face as well as return beam noise.

### OBJECTS AND SUMMARY OF THE INVENTION

It is an object of the present invention to provide a method of manufacturing a semiconductor laser which is capable of effectively preventing light from returning from an optical system to the semiconductor laser, and which can be manufactured and handled with ease and is prevented from damage during fabrication.

According to the present invention, there is provided a method of manufacturing a semiconductor laser comprising the features of appended claim 1.

When the semiconductor laser according to the present invention is used as a light source in an optical pickup for recording information on and reproducing information from an optical disk or the like, the retracted and roughened front surface or surfaces are effective to reduce reentrant light reflected from the semiconductor laser to the optical system of the optical pickup.

Specifically, the retracted and roughened front surface or surfaces reflect returning light from the optical system away from the optical system. As any reentrant light reflected back to the optical system is greatly reduced, any tracking error occurring in the tracking control based on signals produced by the optical pickup is reduced, and a C/N (carrier-to-noise ratio) of signals produced by the optical pickup is improved.

When the front surface or surfaces are formed by dicing, the front surface or surfaces are retracted and optically roughened simultaneously. Consequently, the process of manufacturing the semiconductor laser is simplified.

Inasmuch as only the front surface or surfaces are retracted from the laser beam emission end after the laser diode region is formed, the semiconductor laser is made thin partially and remains mechanically strong enough during formation of the laser diode region. Therefore, while the semiconductor laser is being fabricated, it is prevented from damage and is not required to be handled with utmost care. The rate of defective semiconductor lasers in the yield is rendered relative low.

The above and other objects, features, and advantages of the present invention will become apparent from the following description of illustrative embodiments thereof to be read in conjunction with the accompanying drawings, in which like reference numerals represent the same or similar objects.

### BRIEF DESCRIPTION OF THE DRAWINGS

FIG. 1 is an enlarged perspective view of a semi-conductor laser according to a first embodiment;
FIG. 2A and 2B are fragmentary perspective views illustrative of a process of manufacturing a semiconductor laser according to the present invention;
FIG. 3 is a schematic view of an optical pickup which can incorporate a semiconductor laser produced according to the present invention;
FIG. 4 is an enlarged perspective view of a semiconductor laser according to another embodiment;
FIG. 5 is an enlarged perspective view of a semiconductor laser according to still another embodiment; and
FIG. 6 is an enlarged perspective view of a semiconductor laser according to yet another embodiment.

### DETAILED DESCRIPTION OF THE PREFERRED EMBODIMENTS

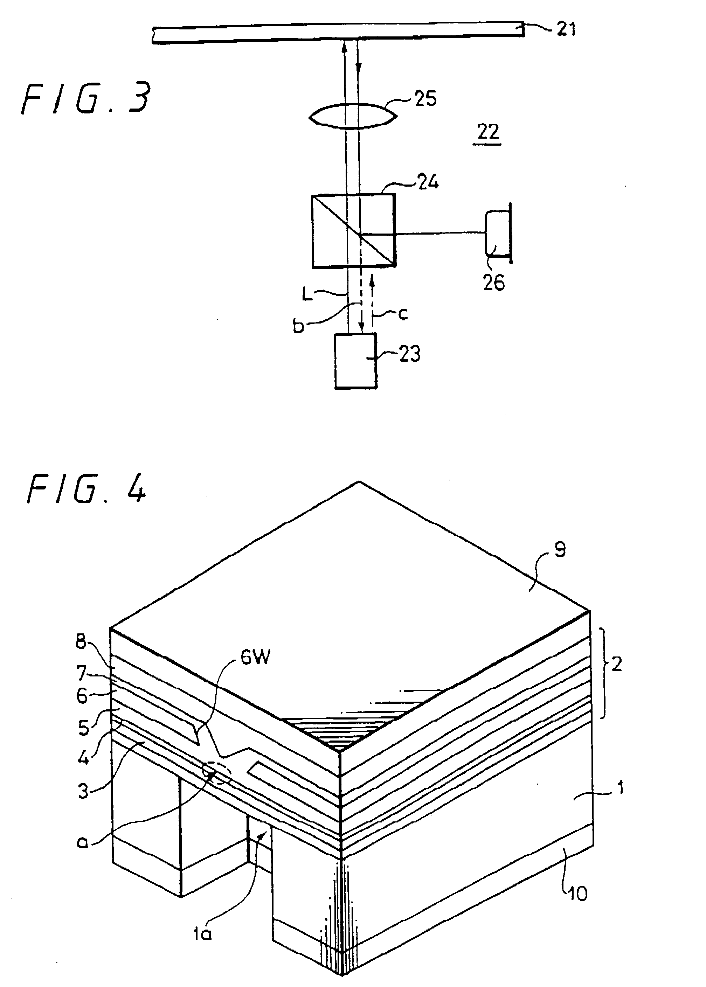

The principles of the present invention are particularly useful when embodied in a semiconductor laser such as a laser diode for use as a light source 23 in an optical pickup 22 as shown in FIG. 3. The optical pickup 22 is used to record information on and reproduce information from an optical disk 21, for example.

When the optical pickup 22 operates in a reproducing mode, a laser beam L emitted from the semiconductor laser of the light source 23 travels through a beamsplitter 24 and an objective 25, and is focused onto an information-recorded surface of the optical disk 21. A portion of light reflected from the information-recorded surface of the optical disk 21 and bearing the recorded information is reflected by the beamsplitter 24 and detected by a light detector 26. The remaining reflected light passes through the beamsplitter 24, and returns to the light source 23 as indicated by the broken line b in FIG. 3. When the light that has returned to the light source 23 is reflected by a front end surface of the semiconductor laser of the light source 23, it reenters the optical system of the optical pickup 22 as indicated by the broken line *c* in FIG. 3.

The semiconductor laser is produced according to the present invention arranged to reduce the reentrant light *c* reflected thereby toward the optical system.

The optical disk 21 may record desired information in the form of pits burned in the surface thereof or may magnetooptically record desired information. The optical pickup 22, which is only schematically shown in FIG. 3, may be of any of various known structures for reproducing the recorded information through optical interference caused by the pits or by way of the magnetooptical effect.

Of course, the semiconductor laser of the light source 23 can be used to emit a laser beam to record desired information on the optical disk 21 when the optical pickup 22 operates in a recording mode.

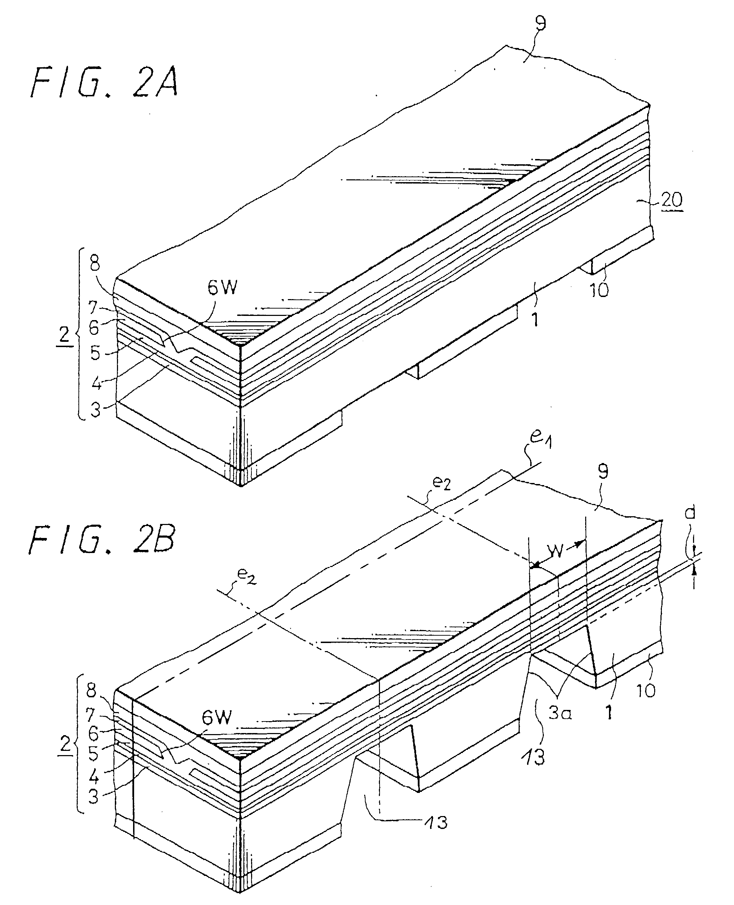

A process of manufacturing a semiconductor laser for use as the light source 23 in FIG. 3 according to the present invention will be described below with reference to FIGS. 2A and 2B.

As shown in FIG. 2A, a laser diode region 2 is formed by way of epitaxial growth on an n-type semiconductor substrate 1 which may be made of GaAs, for example, which may have a thickness of 400 µm, for example. The thickness of the semiconductor substrate 1 may range from 100 µm to 150 µm or further up to 500 µm.

The laser diode region 2 is fabricated as follows: First, an n-type buffer layer (not shown), if necessary, is deposited on the semiconductor substrate 1. Then, an n-type first cladding layer 3 which may be made of AlGaAs, for example, an active layer 4 which may be made of GaAs, for example, a p-type second cladding layer 5 which may be made of AlGaAs, for example, and an n-type current constricting layer 6 are successively deposited on the buffer layer by epitaxial growth. Thereafter, a portion of the current constricting layer 6 is etched away to form a stripe-shaped recess 6W. Then, a p-type third cladding layer 7 which may be made of AlGaAs, for example, is deposited on the current constricting layer 6 including the stripe-shaped recess 6W by epitaxial growth, after which a p-type cap layer 8 which may be made of GaAs, for example, is deposited on the third cladding layer 7 by epitaxial growth.

The semiconductor substrate 1 and the laser diode region 2 formed thereon jointly serve as a wafer 20.

An electrode 9 is then joined to the entire surface of the cap layer 8 by way of ohmic contact. Another electrode 10 is also joined to the reverse surface of the semiconductor substrate 1 except for a diced area (described later on), by way of ohmic contact.

Subsequently, as shown in FIG. 2B, grooves 13 are cut into the semiconductor substrate 1 through the electrode 10 by a dicing machine, leaving a thickness d of the semiconductor substrate 1. The grooves 13 have respective axes extending transversely to the direction in which the stripe-shaped recess 6W extends.

Each of the grooves 13 has a bottom whose width W which may be of 40 µm, for example. The thickness d may be of 60 µm, for example. Each of the grooves 13 has a pair of opposite side wall surfaces 3a which should preferably be respective slanted surfaces flaring away from each other toward the opening of the groove, but may have parallel vertical surfaces.

The side wall surfaces 3a of the grooves 13 that are defined by dicing comprise optically rough surfaces for diffusing light applied thereto, rather than mirror surfaces.

Thereafter, the wafer is cut off, i.e., pelletized into desired semiconductor lasers, along lines transverse to the grooves 13 and lines along the grooves 13 parallel to the cleavage plane of the crystal, as indicated by two-dot-and-dash lines *e*_{*1*}*, e*_{*2*} in FIG. 2B.

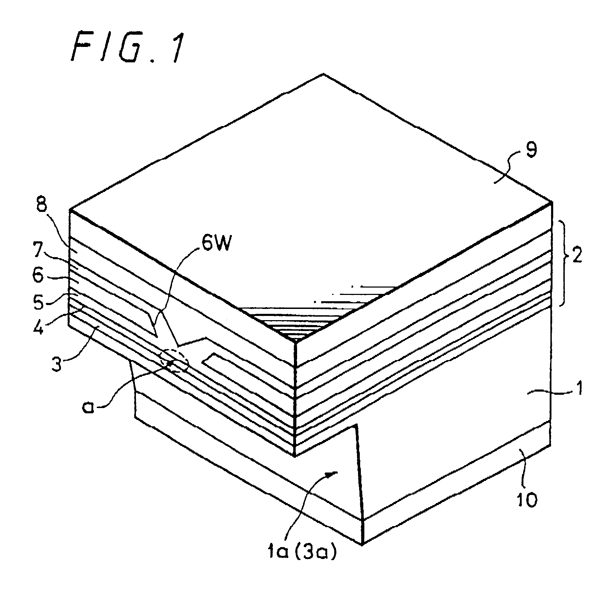

In this manner, a semiconductor laser with the laser diode region 2 disposed on the semiconductor substrate 1 as shown in FIG. 1 is fabricated.

The semiconductor laser thus fabricated has one of the side wall surfaces 3a of the groove 13, i.e., an optically roughened surface, as a front end surface la on the semiconductor substrate 1.

When a forward-biased voltage is applied between the electrodes 9, 10, a current is concentrated on the stripe-shaped recess 6W of the current constricting layer 6, and injected into a portion of the active layer 4 thereby to give rise laser oscillation. Therefore, a laser beam is emitted from a laser beam emission end a on the cleavage plane.

The front end surface la of the semiconductor substrate 1, directly below the laser beam emission end *a*, is sufficiently retracted from the laser beam emission end *a.*

As described above, the front end surface la is retracted from the laser beam emission end *a,* and is an optically roughened surface for diffusing applied light. By suitably selecting the angle of inclination of the front end surface 1a, even though the light *b* (see FIG. 3) returns from the optical system to the semiconductor laser of the light source 23, any reentrant light reflected from the front end surface 1a toward the optical system can be greatly reduced.

FIG. 4 shows a semiconductor laser. In FIG. 4, only a limited partial front surface la where the reentry of light from the semiconductor laser to the optical system would be problematic is retracted from the laser beam emission end *a* as a cavity directly below the laser beam emission end *a* and between other front end surfaces of the semiconductor substrate 1.

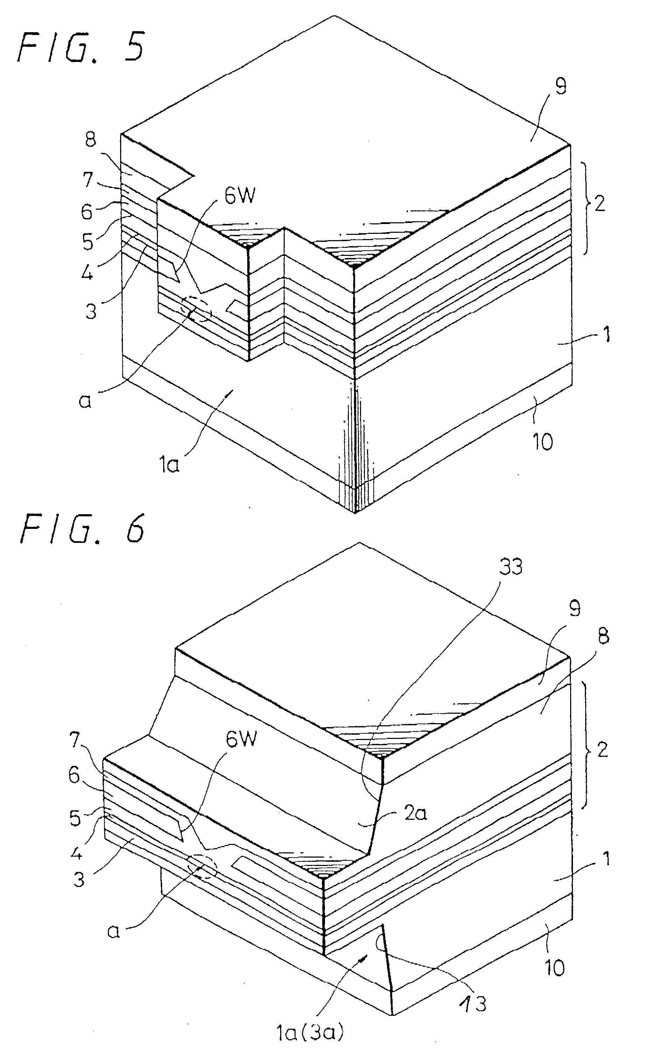

According to FIG. 5, the front end surface 1a of the semiconductor substrate 1 and also limited partial front end surfaces of the laser diode region 2 are retracted from the laser beam emission end a that is positioned between the partial front end surfaces of the laser diode region 2.

FIG. 6 shows another embodiment of a semiconductor laser. In FIG. 6, the p-type cap layer 8 has an increased thickness such that the laser beam emission end a is positioned substantially centrally across the overall thickness of the semiconductor laser. A stripe-shaped groove 33 is defined in the cap layer 8 at the front end of the laser diode region 2 parallel to and aligned with the stripe-shaped groove 13 that is defined in the semiconductor substrate 1. The stripe-shaped groove 33 has a side wall surface as a front end surface 2a of the cap layer 8, which is located directly above and retracted from the laser beam emission end a to prevent light from being reflected and reentering the optical system.

In the above embodiments, the grooves 13, 33 are defined by dicing with the side wall surfaces 3a formed as optically roughened surfaces upon dicing. However, the grooves 13, 33 may be defined by chemical or mechanochemical etching with the side wall surfaces 3a formed as optically roughened surfaces upon chemical or mechanochemical etching.

Alternatively, after the grooves 13, 33 are defined by dicing, the side wall surfaces 3a may be formed as optically roughened surfaces by etching, sputtering, or the like.

More specifically, in FIG. 2B, the side wall surfaces 3a of GaAs may be formed as optically roughened surfaces by an wet etching process with a sulfuric acid etchant under the conditions given in Table 1 below:

**Table 1**

| | H₂SO₄ aq. (96 wt%) | H₂O₂ aq. (98 wt%) | H₂O |
|---|---|---|---|
| Volume ratio | 1 | 10 | 10 |
| Etching time: 1 minute Etching temperature: Room temperature | | | |

If the side wall surfaces 3a formed as optically roughened surfaces upon sputtering, then an argon (Ar) gas should preferably be used under the sputtering conditions given in Table 2 below:

**Table 2**

| | |
|---|---|
| System | Cathode-coupled parallel flat plate RIE system |
| Ar gas | 30 ∼ 50 sccm |
| Pressure | 0.5 Pa |
| RF power | 0.2 W/cm² (13.56 MHz) |
| Substrate bias | 300 V |
| Temperature | Room temperature |
| Time | 2 minutes |

In the illustrated embodiments, the laser diode region 2 is of a double-hetero junction. However, the principles of the present invention are also applicable to any of various other laser diode structures.

As described above, since at least the front end surface la of the semiconductor substrate 1 directly below the laser beam emission end a is retracted from the laser beam emission end a, it is possible to reduce reentrant light into the optical system that is reflected by the front surface of the semiconductor substrate 1 which confronts the optical system. In the case where the front end surface la is an optically roughened surface, it diffuses light applied thereto. In the case where the front end surface la is slanted, it is effective to reduce reentrant light into the optical system as it reflects light away from the optical system.

Inasmuch as the recesses 13 are defined partially in the semiconductor substrate 1 after the laser diode region 2 and the electrodes 9, 10 are formed, the semiconductor laser is mechanically strong enough to avoid damage during formation of the laser diode region 2 and the electrodes 9, 10. Because the mechanically strong semiconductor laser is not required to be handled with utmost care while the laser diode region 2 and the electrodes 9, 10 are being formed, the efficiency of fabrication and the rate of defective semiconductor lasers in the yield are prevented from being lowered.

When the grooves 13 are defined by dicing, the front surface la is retracted and roughened simultaneously with dicing. Therefore, the semiconductor lasers can be mass-produced at a high production rate.

Having described preferred embodiments of the invention with reference to the accompanying drawings, it is to be understood that the invention is not limited to those precise embodiments and that various changes and modifications could be effected by one skilled in the art without departing from the scope of the invention as defined in the appended claims.

## Claims

1. A method of manufacturing a semiconductor laser, comprising the steps of:
depositing a laser diode region (2) on a semiconductor substrate (1), said laser diode region having a laser beam emission region (a), and said semiconductor substrate (1) and said laser diode region (2) jointly serving as a wafer (20);
cutting at least a groove (13) in said semiconductor substrate (1) by dicing, said groove (13) having a pair of opposite side wall surfaces (3a), said side wall surfaces being optically roughened as a result of said dicing; and
cutting off said wafer (20) along lines (e1, e2) transverse to and along said groove (13) so as to form a semiconductor laser, whereby one of said optically roughened side wall surfaces (3a) of said groove (13) forms a front surface (1a) retracted from the laser beam emission end (a) of said semiconductor laser.

2. The method of claim 1, wherein at least a second groove (33) is defined in said laser diode region (2) above said laser beam emission region (a) by dicing, said groove (33) having a pair of opposite side wall surfaces (2a), and said second groove (33) being parallel to and aligned with said groove (13) formed in said semiconductor substrate (1).

3. The method of claims 1 or 2, further comprising the step of further roughening said side wall surfaces (2a, 3a) by etching, sputtering, or the like.

## Patentansprüche

1. Verfahren zum Herstellen eines Halbleiterlasers, mit den folgenden Schritten:
- Abscheiden eines Laserdiodenbereichs (2) auf einem Halbleitersubstrat (1), der einen Laserstrahl-Emissionsbereich (a) aufweist, wobei das Halbleitersubstrat (1) und der Laserdiodenbereich (2) gemeinsam als Wafer (20) dienen;
- Einschneiden mindestens eines Grabens (13) in das Halbleitersubstrat (1) durch einen Zerteilungsvorgang, der ein Paar einander gegenüberstehende Seitenwandflächen (3a) aufweist, die als Ergebnis des Zerteilungsvorgangs optisch aufgerauht sind; und
- Zerschneiden des Wafers (20) entlang Linien quer zum Graben (13) und entlang diesem, um einen Halbleiterlaser auszubilden;
- wobei eine der optisch aufgerauhten Seitenwandflächen (3a) des Grabens (13) eine Vorderfläche (la) bildet, die gegenüber dem Laserstrahl-Emissionsende (a) des Halbleiterlasers eingezogen ist.

2. Verfahren nach Anspruch 1, bei dem mindestens ein zweiter Graben (33) im Laserdiodenbereich (2) über dem Laserstrahl-Emissionsbereich (a) durch einen Zerteilungsvorgang hergestellt wird, wobei dieser Graben (33) ein Paar gegenüberstehende Seitenwandflächen (2a) aufweist und er parallel und ausgerichtet zum im Halbleitersubstrat (1) ausgebildeten Graben (13) verläuft.

3. Verfahren nach Anspruch 1 oder 2, ferner mit dem Schritt des weiteren Aufrauhens der Seitenwandflächen (2a, 3a) durch Ätzen, Sputtern oder dergleichen.

## Revendications

1. Procédé de fabrication d'un laser à semi-conducteur, comprenant les étapes de :
dépôt d'une zone de diode laser (2) sur un substrat semi-conducteur (1), ladite zone de diode laser ayant une zone d'émission de faisceau laser (a), et ledit substrat semi-conducteur (1) et ladite zone de diode laser (2) servant conjointement comme plaquette (20) ;
la découpe d'au moins une gorge (13) dans ledit substrat semi-conducteur (1) par découpe, ladite gorge (13) ayant une paire de surfaces de paroi latérale opposées (3a), lesdites surfaces de paroi latérale étant dépolies optiquement comme un résultat de ladite découpe ; et
découpe de ladite plaquette (20) le long des lignes (e₁ ; e₂) transverses et le long de ladite gorge (13) afin de former un laser à semi-conducteur, de sorte qu'une desdites surfaces de paroi latérale dépolies optiquement (3a) de ladite gorge (13) forme une surface avant (la) en retrait par rapport à l'extrémité d'émission de faisceau laser (a) dudit laser à semi-conducteur.

2. Procédé selon la revendication 1, dans lequel au moins une seconde gorge (33) est définie dans ladite zone de diode laser (2) au-dessus de ladite zone d'émission de faisceau laser (a) par découpe, ladite gorge (33) ayant une paire de surfaces de paroi latérale opposées (2a), et ladite seconde gorge (33) étant parallèle et alignée avec ladite gorge (13) formée dans ledit substrat semi-conducteur (1).

3. Procédé selon la revendication 1 ou 2, comprenant en outre l'étape de dépolissage supplémentaire desdites surfaces de paroi latérale (2a, 3a) par gravure, pulvérisation ou autre.
